# EUROPEAN PATENT APPLICATION

(11) **EP 4 257 644 A1**
(43) Date of publication of application: **11.10.2023**
(21) Application number: 21910162.3
(22) Date of filing: 30.11.2021
(51) Int. Cl.: C09D 1/00, B82Y 30/00, B82Y 40/00, C08K 3/22, C08K 5/09, C08L 101/00, H01L 21/027

(54) **METAL OXIDE FILM-FORMING COMPOSITION, METHOD FOR PRODUCING METAL OXIDE FILMS USING SAME, AND METHOD FOR REDUCING VOLUME SHRINKAGE RATIO OF METAL OXIDE FILMS**

(30) Priority: 24.12.2020 JP 2020214869
(71) Applicant: TOKYO OHKA KOGYO CO., LTD., Kawasaki-shi, Kanagawa 211 0012 (JP)
(72) Inventor: YAMAUCHI Kenichi, Kawasaki-shi, Kanagawa 211-0012 (JP); NODA Kunihiro, Kawasaki-shi, Kanagawa 211-0012 (JP); SHIOTA Dai, Kawasaki-shi, Kanagawa 211-0012 (JP)
(74) Representative: Plasseraud IP
(86) International application number: PCT/JP2021/043781
(87) International publication number: WO 2022/138010

(57) **Abstract**

Provided are: a metal oxide film-forming composition that yields a metal oxide film that exhibits a suppression of volume shrinkage in heating up to 400°C; a method for producing metal oxide films that uses the metal oxide film-forming composition; and a method for reducing the volume shrinkage ratio of metal oxide films. A metal oxide film-forming composition according to the present invention comprises metal oxide nanoclusters, a capping agent, a base material, and solvent. The size of the metal oxide nanoclusters is not more than 5 nm, and the capping agent comprises at least one selected from the group consisting of alkoxysilanes, phenols, alcohols, carboxylic acids, and carboxylic acid halides. In the solid fraction of the metal oxide film-forming composition, the proportion of the mass of the inorganic fraction, with reference to the sum of the mass of the inorganic fraction and the mass of the organic fraction, is at least 25 mass%.

## Description

### TECHNICAL FIELD

The present invention relates to a metal oxide film-forming composition, a method for producing a metal oxide film using the composition, and a method for forming a metal oxide film with reduced volume shrinkage ratio.

### BACKGROUND ART

A common etching process for semiconductor device manufacturing or the like includes applying a resist material, such as a photoresist or an electron beam resist, to the surface of a substrate to be etched; patterning the resist material by lithography to form a patterned resist film; and etching the substrate using the patterned resist film as an etching mask to form a specific pattern on the substrate.

In this process, the resist film may fail to adequately function as an etching mask depending on the etch rate of the substrate due to low etch selectivity between the substrate and the resist film. To address such a problem, a substrate etching process includes forming an etching mask known as a hard mask, which provides high etch selectivity between the substrate and the etching mask. A known hard mask includes, for example, a metal oxide film including metal oxide nanoparticles, such as zirconium oxide nanoparticles (see Patent Document 1).

Patent Document 1: Japanese Unexamined Patent Application (Translation of PCT Application), Publication No. 2020-503409

### DISCLOSURE OF THE INVENTION

### Problems to be Solved by the Invention

Such a conventional metal oxide film including metal oxide nanoparticles is formed by heating a coating film of a composition containing metal oxide nanoparticles. As a result of studies, the inventors have found that such a conventional metal oxide film exhibits relatively high volume shrinkage when heated at a low temperature of 400°C or less and thus has low in-plane uniformity after being subjected to the main baking at a high temperature of 450°C, so that the use of the resulting metal oxide film as a hard mask may make it difficult to perform uniform dry etching.

It is an object of the present invention, which has been made in view of such conventional circumstances, to provide a metal oxide film-forming composition capable of forming a metal oxide film that exhibits low volume shrinkage when heated at 400°C or less, to provide a method for producing a metal oxide film using such a composition, and to provide a method for forming a metal oxide film with reduced volume shrinkage ratio.

### Means for Solving the Problems

The inventors have conducted intensive studies to solve the problem described above. As a result, the inventors have completed the present invention based on findings that the problem can be solved using a metal oxide film-forming composition that includes metal oxide nanoclusters with a specific size; a specific capping agent; a base material; and a solvent and contains solids with a ratio of inorganic mass to total inorganic and organic mass of 25 mass% or more. Specifically, the present invention provides the following aspects.

A first aspect of the present invention is directed to a metal oxide film-forming composition including: metal oxide nanoclusters; a capping agent; a base material; and a solvent, the metal oxide nanoclusters having a size of 5 nm or less, the capping agent including at least one selected from the group consisting of an alkoxysilane, a phenol, an alcohol, a carboxylic acid, and a carboxylic acid halide, the metal oxide film-forming composition containing solids with a ratio of inorganic mass to total inorganic and organic mass of 25 mass% or more.

A second aspect of the present invention is directed to a method for producing a metal oxide film, the method including: a coating film formation step that includes forming a coating film including the metal oxide film-forming composition according to the first aspect; and
a heating step that includes heating the coating film.

A third aspect of the present invention is directed to a method for forming a metal oxide film with a reduced volume shrinkage ratio, the method including: forming a coating film including a metal oxide film-forming composition; and heating the coating film,
the metal oxide film-forming composition including: metal oxide nanoclusters; a capping agent; a base material; and a solvent,
the metal oxide nanoclusters having a size of 5 nm or less, the capping agent including at least one selected from the group consisting of an alkoxysilane, a phenol, an alcohol, a carboxylic acid, and a carboxylic acid halide,
the metal oxide film-forming composition containing solids with a ratio of inorganic mass to total inorganic and organic mass of 25 mass% or more.

### Effects of the Invention

The present invention provides a metal oxide film-forming composition capable of forming a metal oxide film that exhibits low volume shrinkage when heated at 400°C or less, provides a method for producing a metal oxide film using such a composition, and provides a method for forming a metal oxide film with reduced volume shrinkage ratio.

### PREFERRED MODE FOR CARRYING OUT THE INVENTION

### Metal Oxide Film-Forming Composition

The present invention is directed to a metal oxide film-forming composition including: metal oxide nanoclusters; a capping agent; a base material; and a solvent. The metal oxide film-forming composition according to the present invention is capable of forming a metal oxide film that exhibits low volume shrinkage when heated at 400°C or less.

In the solids of the metal oxide film-forming composition, the ratio of the inorganic mass to the total inorganic and organic mass is 25 mass% or more, preferably 30 mass% or more, more preferably 40 mass% or more. Within such a range, the inorganic mass ratio can be set so high as to allow the formation of a metal oxide film that exhibits low volume shrinkage when heated at a low temperature of 400°C or less. The upper limit of the ratio may be, but not limited to, 90 mass%, 80 mass%, or 75 mass%.

### Metal Oxide Nanoclusters

As used herein, the term "metal oxide nanocluster" refers to a group of metal oxide molecules that form multiple faces. The metal oxide nanoclusters consist of metal oxide molecules and contain no capping agent. The metal oxide film-forming composition according to the present invention, which contains metal oxide nanoclusters together with a capping agent, will form a metal oxide film that tends to exhibit low volume shrinkage when heated at a low temperature of 400°C or less.

In the X-ray diffraction analysis of the metal oxide nanoclusters, diffraction peaks are detected corresponding to the faces mentioned above. The metal oxide nanoclusters may include crystals, microcrystals, or amorphous phases. The detected X-ray diffraction pattern of the metal oxide nanoclusters has peaks, broad peaks, or broad halo patterns, which are derived from the faces (crystal planes) of the metal atoms, depending on the components of the metal oxide nanoclusters. If the detected X-diffraction pattern of a certain sample has neither a peak nor even a broad peak or halo pattern, the sample should be determined to contain no metal oxide nanocluster according to the specification.

The metal oxide nanoclusters have a size of 5 nm or less, preferably a size of 4 nm or less, more preferably a size of 3 nm or less. The lower limit of the size of the metal oxide nanoclusters is typically, but not limited to, 0.5 nm or more, 1 nm or more, or 2 nm or more. If the metal oxide nanoclusters have a size of more than 5 nm, the resulting metal oxide film will be less likely to exhibit low volume shrinkage when heated at a low temperature of 400°C or less. This means that the metal oxide film will tend to have low in-plane uniformity after being subjected to the main baking at a high temperature of 450°C, so that the use, as a hard mask, of the metal oxide film resulting from the main baking will often make it difficult to perform uniform dry etching. As used herein, the term "the size of metal oxide nanoclusters" refers to the value calculated by the Halder-Wagner method from the full width at half maximum of the scattering peak in the spectrum detected by X-ray scattering intensity distribution measurement.

Examples of the metal in the metal oxide nanoclusters include, but are not limited to, zinc, yttrium, hafnium, zirconium, lanthanum, cerium, neodymium, gadolinium, holmium, lutetium, tantalum, titanium, silicon, aluminum, antimony, tin, indium, tungsten, copper, vanadium, chromium, niobium, molybdenum, ruthenium, rhodium, rhenium, iridium, germanium, gallium, thallium, and magnesium, among which in terms of stability and film forming ability, for example, zinc, yttrium, hafnium, and zirconium are preferred, and zirconium is more preferred. These metals may be used alone, or two or more of these metals may be used in any combination.

The amount of the metal oxide nanoclusters in the metal oxide film-forming composition is typically, but not limited to, 45 to 75 mass%, preferably 50 to 72 mass%, based on the total mass of the components other than the solvent in the metal oxide film-forming composition. When the amount of the metal oxide nanoclusters falls within such a range, the resulting metal oxide film will tend to exhibit low volume shrinkage when heated at a low temperature of 400°C or less.

### Capping Agent

In the metal oxide film-forming composition according to the present invention, some or all of the metal oxide nanoclusters are presumed to be covered with the capping agent. The capping agent includes at least one selected from the group consisting of an alkoxysilane, a phenol, an alcohol, a carboxylic acid, and a carboxylic acid halide. The metal oxide film-forming composition according to the present invention, which contains the capping agent together with the metal oxide nanoclusters, will form a metal oxide film that tends to exhibit low volume shrinkage when heated at a low temperature of 400°C or less.

Examples of the capping agent include n-propyltrimethoxysilane, n-propyltriethoxysilane, n-octyltrimethoxysilane, n-octyltriethoxysilane, n-dodecyltrimethoxysilane, n-dodecyltriethoxysilane, n-hexadecyltrimethoxysilane, n-hexadecyltriethoxysilane, n-octadecyltrimethoxysilane, n-octadecyltriethoxysilane, phenyltrimethoxysilane, phenyltriethoxysilane, phenethylphenyltrimethoxysilane, phenethylethyltriethoxysilane, 3-{2-methoxy[poly(ethyleneoxy)]}propyltrimethoxysilane, 3-{2-methoxy[poly(ethyleneoxy)]}propyltriethoxysilane, 3-{2-methoxy[tri(ethyleneoxy)]}propyltrimethoxysilane, 3-{2-methoxy[tri(ethyleneoxy)] }propyltriethoxysilane, vinyltrimethoxysilane, vinyltriethoxysilane, allyltrimethoxysilane, allyltriethoxysilane, 1-hexenyltrimethoxysilane, 1-hexenyltriethoxysilane, 1-octenyltrimethoxysilane, 1-octenyltriethoxysilane, 3-aminopropyltrimethoxysilane, 3-aminopropyltriethoxysilane, 3-mercaptopropyltrimethoxysilane, 3-mercaptopropyltriethoxysilane, 3-acryloyloxypropyltrimethoxysilane, 3-acryloylpropyltriethoxysilane, 3-methacryloyloxypropyltrimethoxysilane, 3-methacryloyloxypropyltriethoxysilane, 3-isocyanatopropyltrimethoxysilane, 3-isocyanatopropyltriethoxysilane, 3-glycidoxypropyltrimethoxysilane, 3-glycidoxypropyltriethoxysilane, and other alkoxysilanes; ethanol, n-propanol, isopropanol, n-butanol, n-heptanol, n-hexanol, n-octanol, oleyl alcohol, n-dodecyl alcohol, n-octadecanol, benzyl alcohol, phenol, triethylene glycol monomethyl ether, and other alcohols or phenols; octanoic acid, acetic acid, propionic acid, 2-[2-(methoxyethoxy)ethoxy]acetic acid, oleic acid, lauric acid, benzoic acid, 2-acryloyloxyethyl succinate, 2-acryloyloxyethyl phthalate, and other acids; and acid halides of these acids, such as acid chlorides of these acids, among which phenols, alcohols, or acids are preferred.

The amount of the capping agent in the metal oxide film-forming composition is typically, but not limited to, 10 to 35 mass%, preferably 18 to 28 mass%, based on the total mass of the components other than the solvent in the metal oxide film-forming composition. When the amount of the capping agent falls within such a range, the organic mass ratio of the composition will remain not too high, which will result in the formation of a metal oxide film that tends to exhibit low volume shrinkage when heated at a low temperature of 400°C or less.

In the solids of the metal oxide film-forming composition, the ratio of the mass of the metal oxide nanoclusters to the total mass of the metal oxide nanoclusters and the capping agent is typically 50 mass% or more, preferably 55 mass% or more, more preferably 60 mass% or more, even more preferably 65 mass% or more. The upper limit of the mass ratio is typically 95 mass% or less, preferably 90 mass% or less.

### Base Material

The metal oxide film-forming composition according to the present invention contains a base material for the purpose of controlling the ability of the composition to form a coating film or to be applied. The composition may contain a single base material or a combination of two or more base materials. The base material may be, but not limited to, a polymer, such as a resin, or a non-polymer material, such as a low molecular weight compound.

The base material may have any mass average molecular weight (hereinafter referred to as "Mw") that does not compromise the object of the present invention. The base material preferably has a Mw of 700 or more and 40,000 or less, more preferably a Mw of 900 or more and 30,000 or less, even more preferably a Mw of 1,000 or more and 20,000 or less. The base material with a Mw in such a range easily allows the composition to have a high ability to form a coating film or to be applied. When used as the base material, a polymer with a Mw of 4,000 or less or a non-polymer material with a Mw of 4,000 or less would have a high ability to fill gaps on an uneven substrate. As used herein, the term "Mw" refers to the polystyrene-equivalent value determined by gel permeation chromatography (GPC).

### Acrylic Resin (a-IV)

The base material may be an acrylic resin (a-IV) including a (meth)acrylic acid-derived structural unit and/or a structural unit derived from any other monomer, such as a (meth)acrylic acid ester. The term "(meth)acrylic acid" means acrylic acid or methacrylic acid. The typical structural unit of the acrylic resin (a-IV) is preferably derived from a compound represented by formula (a-4-1) below.

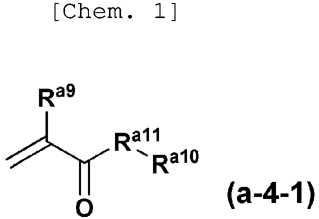

In formula (a-4-1), R^{a9} is a hydrogen atom or a methyl group;
R^{a10} is a hydrogen atom or a monovalent organic group;
the organic group may have a bond other than that in a hydrocarbon group or have a substituent other than a hydrocarbon group, such as a heteroatom;
the organic group may be linear, branched, or cyclic;
R^{a11} is a group represented by -O- or -NR^{a12}-; and
R^{a12} is a hydrogen atom or an alkyl group having 1 or more and 6 or less carbon atoms.

In the organic group of R^{a10}, the substituent other than a hydrocarbon group may be any type that does not compromise the object of the present invention, examples of which include halogen atoms, hydroxyl, mercapto, sulfide, cyano, isocyano, cyanato, isocyanato, thiocyanato, isothiocyanato, silyl, silanol, alkoxy, alkoxycarbonyl, carbamoyl, thiocarbamoyl, nitro, nitroso, carboxy, carboxylate, acyl, acyloxy, sulfino, sulfo, sulfonato, phosphino, phosphinyl, phosphono, phosphonato, hydroxyimino, alkyl ether, alkyl thioether, aryl ether, aryl thioether, and amino (-NH₂, -NHR, or -NRR', wherein R and R' each independently represent a hydrocarbon group). Any hydrogen atom in the substituent may be replaced by a hydrocarbon group. The hydrocarbon group in the substituent may be linear, branched, or cyclic.

The organic group of R^{a10} may have a reactive functional group, such as acryloyloxy, methacryloyloxy, epoxy, or oxetanyl. For example, when the acrylic resin (a-IV) includes an epoxy-containing structural unit, an acyl group having an unsaturated double bond, such as an acryloyloxy or methacryloyloxy group, may be formed in the acrylic resin (a-IV) by the reaction of at least some of the epoxy groups with an unsaturated carboxylic acid, such as acrylic acid or methacrylic acid. The reaction of at least some of the epoxy groups with an unsaturated carboxylic acid may be followed by the reaction of the formed group with a polybasic acid anhydride.

Examples of the polybasic acid anhydride include maleic anhydride, succinic anhydride, itaconic anhydride, phthalic anhydride, tetrahydrophthalic anhydride, hexahydrophthalic anhydride, methyl hexahydrophthalic anhydride, methyl tetrahydrophthalic anhydride, trimellitic anhydride, pyromellitic anhydride, benzophenone tetracarboxylic dianhydride, 3-methylhexahydrophthalic anhydride, 4-methylhexahydrophthalic anhydride, 3-ethylhexahydrophthalic anhydride, 4-ethylhexahydrophthalic anhydride, tetrahydrophthalic anhydride, 3-methyltetrahydrophthalic anhydride, 4-methyltetrahydrophthalic anhydride, 3-ethyltetrahydrophthalic anhydride, and 4-ethyltetrahydrophthalic anhydride.

An unsaturated double bond may also be introduced into the acrylic resin (a-IV) by the reaction of a compound having an epoxy group and an unsaturated double bond with the structural unit of the acrylic resin (a-IV) derived from an unsaturated carboxylic acid, such as acrylic or methacrylic acid. The compound having an epoxy group and an unsaturated double bond may be, for example, glycidyl (meth)acrylate or a compound represented by one of formulas (a-4-1a) to (a-4-1o) shown below.

R^{a10} is preferably alkyl, aryl, cycloalkyl, polycycloalkyl, cycloalkylalkyl, polycycloalkylalkyl, aralkyl, or a heterocyclic group, which may be substituted with a halogen atom, a hydroxyl group, an alkyl group, or a heterocyclic group or may have an epoxy group formed by the coupling of an oxygen atom with any one of these groups. These groups may also have an alkylene moiety. In such a case, the alkylene moiety may be interrupted by an ether bond, a thioether bond, or an ester bond.

In a case where the alkyl group is linear or branched, it preferably has 1 or more and 20 or less carbon atoms, more preferably 1 or more and 15 or less carbon atoms, even more preferably 1 or more and 10 or less carbon atoms. Preferred examples of the alkyl group include methyl, ethyl, n-propyl, isopropyl, n-butyl, isobutyl, sec-butyl, tert-butyl, n-pentyl, isopentyl, sec-pentyl, tert-pentyl, n-hexyl, n-heptyl, n-octyl, isooctyl, sec-octyl, tert-octyl, n-nonyl, isononyl, n-decyl, and isodecyl.

Preferred examples of the cyclic group in the cycloalkyl, polycycloalkyl, cycloalkylalkyl, polycycloalkylalkyl, and other cyclic group-containing groups include monocyclic groups, such as cyclopentyl and cyclohexyl; and polycycloalkyl groups, such as adamantyl, norbornyl, isobornyl, tricyclononyl, tricyclodecyl, tetracyclododecyl, bicyclo-[2.1.1]-hexyl, bicyclo-[2.2.1]-heptyl, bicyclo-[2.2.2]-octyl, bicyclo-[3.3.0]-octyl, bicyclo-[4.3.0]-nonyl, and bicyclo-[4.4.0]-decyl.

Preferred examples of the compound of formula (a-4-1) with R^{a10} being cycloalkyl, polycycloalkyl, cycloalkylalkyl, polycycloalkylalkyl, or any other cyclic group-containing group include compounds represented by formulas (a-4-1a) to (a-4-1h) below. Among them, compounds represented by formulas (a-4-1c) to (a-4-1h) below are preferred, and compounds represented by formula (a-4-1c) or (a-4-1d) below are more preferred.

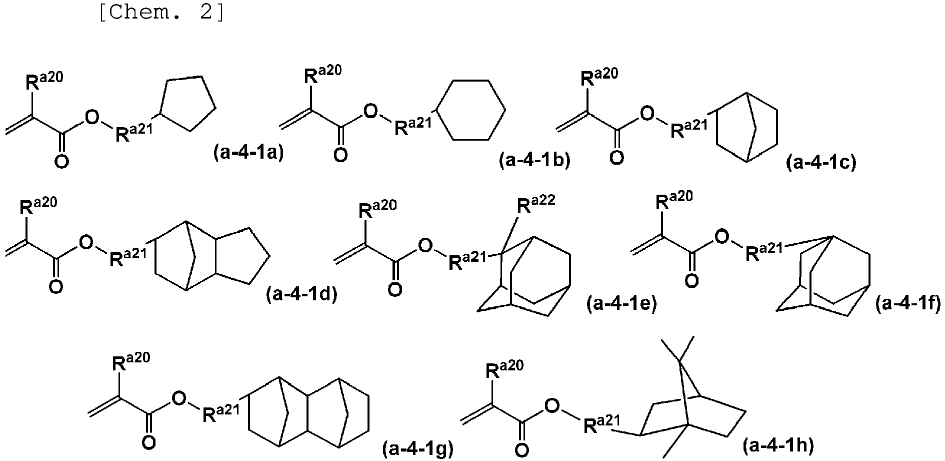

In the formulas, R^{a20} represents a hydrogen atom or a methyl group, R^{a21} represents a single bond or a divalent aliphatic saturated hydrocarbon group having 1 to 6 carbon atoms, and R^{a22} represents a hydrogen atom or an alkyl group having 1 to 5 carbon atoms. R^{a21} is preferably a single bond or a linear or branched alkylene group, such as methylene, ethylene, propylene, tetramethylene, ethylethylene, pentamethylene, or hexamethylene. R^{a22} is preferably, for example, methyl or ethyl.

The base material preferably includes an acrylic resin including a structural unit derived from polycycloalkyl (meth)acrylate (A-1) and/or a structural unit derived from aralkyl (meth)acrylate (A-2). For the advantageous effects of the present invention, the acrylic resin preferably includes a structural unit derived from polycycloalkyl (meth)acrylate (A-1), for example, represented by any one of formulas (a-4-1c) to (a-4-1h) above with R^{a21} being a single bond.

Examples of the compound of formula (a-4-1) with R^{a10} being an epoxy-containing chain group include glycidyl (meth)acrylate, 2-methylglycidyl (meth)acrylate, 3,4-epoxybutyl (meth)acrylate, 6,7-epoxyheptyl (meth)acrylate, and other epoxyalkyl (meth)acrylate esters.

The compound of formula (a-4-1) may also be an alicyclic epoxy-containing (meth)acrylic acid ester. The alicyclic group in the alicyclic epoxy group may be monocyclic or polycyclic. Examples of the monocyclic alicyclic group include cycloalkyl groups, such as cyclopentyl and cyclohexyl. Examples of the polycyclic alicyclic group include norbornyl, isobornyl, tricyclononyl, tricyclodecyl, tetracyclododecyl, and other polycycloalkyl groups.

Examples of the compound of formula (a-4-1) being an alicyclic epoxy-containing (meth)acrylate include compounds represented by formulas (a-4-1i) to (a-4-1m) below.

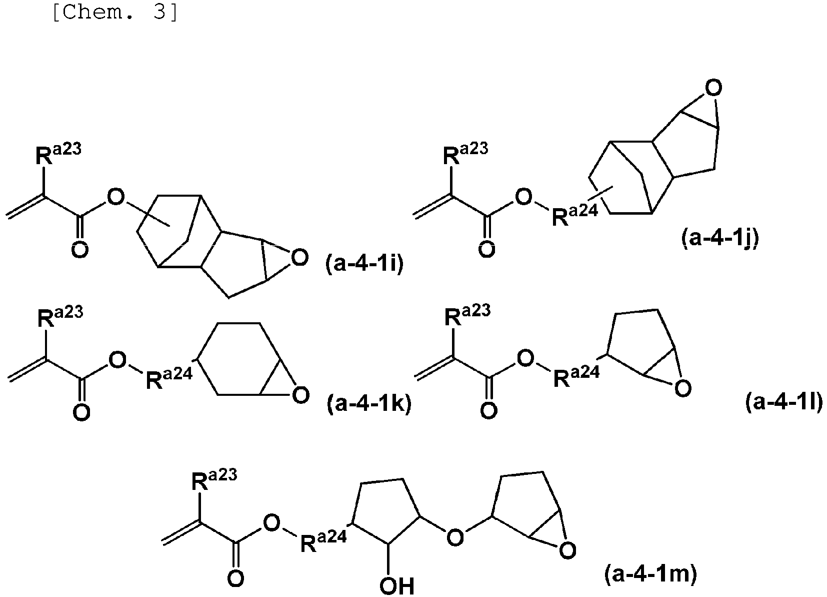

Other examples of the compound of formula (a-4-1) include (meth)acrylic acid, 2-hydroxyethyl (meth)acrylate, 2-hydroxypropyl (meth)acrylate, 2-hydroxy-3-phenoxypropyl (meth)acrylate, 2-(meth)acryloyloxyethyl succinate, 2-(meth)acryloyloxyethyl phthalate, 2-(meth)acryloyloxyethyl-2-hydroxyethyl phthalate, mono-2-(meth)acryloyloxyethyl acid phosphate, di-2-(meth)acryloyloxyethyl acid phosphate, 2-hydroxybutyl (meth)acrylate, 2-(meth)acryloyloxyethyl hexahydrophthalate, glycerol di(meth)acrylate, 2-hydroxy-3-phenoxypropyl (meth)acrylate, bisphenol A diglycidyl ether (meth)acrylic acid adducts, o-phenylphenol glycidyl ether (meth)acrylate, 1,4-butanediol diglycidyl ether di(meth)acrylate, 1,6-hexanediol diglycidyl ether di(meth)acrylate, dipropylene glycol diglycidyl ether di(meth)acrylate, pentaerythritol polyglycidyl ether (meth)acrylate, 1,3-propanediol diglycidyl ether (meth)acrylate, cyclohexanedimethanol diglycidyl ether (meth)acrylate, 1,6-hexanediol diglycidyl ether (meth)acrylate, glycerol polyglycidyl ether (meth)acrylate, ethylene glycol diglycidyl ether (meth)acrylate, polyethylene glycol diglycidyl ether (meth)acrylate, dipropylene glycol diglycidyl ether (meth)acrylate, polypropylene glycol diglycidyl ether (meth)acrylate, 2-hydroxyethyl (meth)acrylate, 1-acryloyloxyethyl (meth)acrylate, 1,2,3-propanetriol 1,3-di(meth)acrylate, 2-carboxyethyl (meth)acrylate, and other (meth)acrylic monomers.

For the advantageous effects of the present invention, the compound for the structural unit of the acrylic resin (a-IV) is preferably (meth)acrylic acid, 2-(meth)acryloyloxyethyl succinate, 2-(meth)acryloyloxyethyl phthalate, 2-(meth)acryloyloxyethyl-2-hydroxyethyl phthalate, C₁-C₅ alkyl (meth)acrylate, polycycloalkyl (meth)acrylate (A-1), or aralkyl (meth)acrylate (A-2). The polycycloalkyl (meth)acrylate (A-1) may be, for example, one of compounds represented by formulas (a-4-1c) to (a-4-1h) with R^{a21} being a single bond, and the aralkyl (meth)acrylate (A-2) may be, for example, benzyl (meth)acrylate.

In the acrylic resin (a-IV), the content of the structural unit derived from one of the preferred compounds above may be any level that does not compromise the object of the present invention and is typically 10 mass% or more, preferably 30 mass% or more, based on the total mass of all structural units. The content of the structural unit may have any suitable upper limit, which may be, for example, 100 mass% or less or 90 mass% or less.

Alternatively, the acrylic resin (a-IV) may be a polymer of a monomer other than (meth)acrylic acid esters. Examples of such a monomer include (meth)acrylamides, unsaturated carboxylic acids, allyl compounds, vinyl ethers, vinyl esters, and styrenes, among which vinyl ethers or styrenes are preferred. These monomers may be used alone, or two or more of these monomers may be used in any combination.

The (meth)acrylamides include (meth)acrylamide, N-alkyl(meth)acrylamide, N-aryl(meth)acrylamide, N,N-dialkyl(meth)acrylamide, N,N-aryl(meth)acrylamide, N-methyl-N-phenyl(meth)acrylamide, and N-hydroxyethyl-N-methyl(meth)acrylamide.

The unsaturated carboxylic acids include monocarboxylic acids, such as crotonic acid; dicarboxylic acids, such as maleic acid, fumaric acid, citraconic acid, mesaconic acid, and itaconic acid; and anhydrides of these dicarboxylic acids.

The allyl compounds include allyl esters, such as allyl acetate, allyl caproate, allyl caprylate, allyl laurate, allyl palmitate, allyl stearate, allyl benzoate, allyl acetoacetate, and allyl lactate; and allyloxyethanol.

The vinyl ethers include hexyl vinyl ether, octyl vinyl ether, decyl vinyl ether, ethylhexyl vinyl ether, methoxyethyl vinyl ether, ethoxyethyl vinyl ether, chloroethyl vinyl ether, 1-methyl-2,2-dimethylpropyl vinyl ether, 2-ethylbutyl vinyl ether, hydroxyethyl vinyl ether, diethylene glycol vinyl ether, dimethylaminoethyl vinyl ether, diethylaminoethyl vinyl ether, butylaminoethyl vinyl ether, benzyl vinyl ether, tetrahydrofurfuryl vinyl ether, and other alkyl vinyl ethers; and vinyl phenyl ether, vinyl tolyl ether, vinyl chlorophenyl ether, vinyl 2,4-dichlorophenyl ether, vinyl naphthyl ether, vinyl anthranil ether, and other vinyl aryl ethers.

The vinyl esters include vinyl butyrate, vinyl isobutyrate, vinyl trimethylacetate, vinyl diethylacetate, vinyl valerate, vinyl caproate, vinyl chloroacetate, vinyl dichloroacetate, vinyl methoxyacetate, vinyl butoxyacetate, vinyl phenylacetate, vinyl acetoacetate, vinyl lactate, vinyl β-phenylbutyrate, vinyl benzoate, vinyl salicylate, vinyl chlorobenzoate, vinyl tetrachlorobenzoate, and vinyl naphthoate.

The styrenes include styrene; methylstyrene, dimethylstyrene, trimethylstyrene, ethylstyrene, diethylstyrene, isopropylstyrene, butylstyrene, hexylstyrene, cyclohexylstyrene, decylstyrene, benzylstyrene, chloromethylstyrene, trifluoromethylstyrene, ethoxymethylstyrene, acetoxymethylstyrene, and other alkylstyrenes; methoxystyrene, 4-methoxy-3-methylstyrene, dimethoxystyrene, and other alkoxystyrenes; and chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluoromethylstyrene, 4-fluoro-3-trifluoromethylstyrene, and other halostyrenes.

Even when the base material is an acrylic resin, the metal oxide film-forming composition according to the present invention can provide a desired level of etch resistance for substrate processing since it contains the metal oxide nanoclusters. To increase the etch resistance, however, the metal oxide film-forming composition according to the present invention may further include, as a base material, an aromatic ring-containing polymer, an aromatic ring-containing, non-polymer material, or both of them.

The aromatic ring-containing, non-polymer material may be a compound (X) having a bisphenylfluorene skeleton, a bisnaphthylfluorene skeleton, a methylenedinaphthalene skeleton, a tetrabenzonaphthalene skeleton, or a calixarene skeleton. Such a compound may have a substituent. For curing properties, the substituent is preferably, for example, a polymerizable group, such as acryloyl, methacryloyl, vinyloxy, styryl, allyl, propargyl, diglycidylamino, or dipropargylamino, or an organic group having such an polymerizable group.

The aromatic ring-containing polymer may be, for example,
a resin including a repeating structure having the skeleton of the compound (X),
a resin including a repeating structure having a benzene skeleton, a naphthalene skeleton, a biphenyl skeleton, and/or an anthracene skeleton, or
a compound (X) condensation product. The condensation product may be produced by allowing the compound (X) to react with one or more selected from the group consisting of aldehydes, alkoxy group-containing compounds, alkanoyloxy group-containing compounds, trioxanes, and fluorenones. The aromatic ring-containing polymer may also be a known novolac resin or the like.

### Novolac Resin (a-II)

The novolac resin (a-II) may be any of various types used in conventional photosensitive compositions. The novolac resin (a-II) is preferably a polymer produced by addition-condensation of one or more phenolic hydroxyl group-containing aromatic compounds (hereinafter simply referred to as "phenols") with one or more aldehydes in the presence of an acid catalyst.

### Phenols

The phenols for use in the production of the novolac resin (a-II) include, for example, phenol; cresols, such as o-cresol, m-cresol, and p-cresol; xylenols, such as 2,3-xylenol, 2,4-xylenol, 2,5-xylenol, 2,6-xylenol, 3,4-xylenol, and 3,5-xylenol; ethylphenols, such as o-ethylphenol, m-ethylphenol, and p-ethylphenol; alkylphenols, such as 2-isopropylphenol, 3-isopropylphenol, 4-isopropylphenol, o-butylphenol, m-butylphenol, p-butylphenol, and p-tert-butylphenol; trialkylphenols, such as 2,3,5-trimethylphenol and 3,4,5-trimethylphenol; polyvalent phenols, such as resorcinol, catechol, hydroquinone, hydroquinone monomethyl ether, pyrogallol, and phloroglucinol; polyvalent alkylphenols, such as alkylresorcinol, alkylcatechol, and alkylhydroquinone (in which any alkyl group has 1 or more and 4 or less carbon atoms); and α-naphthol; β-naphthol; hydroxydiphenyl; and bisphenol A. These phenols may be used alone, or two or more of these phenols may be used in any combination.

### Aldehydes

The aldehydes for use in the production of the novolac resin (a-II) include, for example, formaldehyde, paraformaldehyde, furfural, benzaldehyde, nitrobenzaldehyde, and acetaldehyde. These aldehydes may be used alone, or two or more of these aldehydes may be used in any combination.

### Acid Catalyst

Examples of the acid catalyst for use in the production of the novolac resin (a-II) include inorganic acids, such as hydrochloric acid, sulfuric acid, nitric acid, phosphoric acid, and phosphorus acid; organic acids, such as formic acid, oxalic acid, acetic acid, diethyl sulfuric acid, and p-toluenesulfonic acid; and metal salts, such as zinc acetate. These acid catalysts may be used alone, or two or more of these acid catalysts may be used in any combination.

The amount of the base material in the metal oxide film-forming composition is typically, but not limited to, 0.5 to 35 mass%, preferably 1 to 25 mass%, more preferably 2 to 15 mass%, based on the total mass of the components other than the solvent in the metal oxide film-forming composition. When the amount of the base material falls within such a range, the organic mass ratio of the composition will remain not too high, which will result in the formation of a metal oxide film that tends to exhibit low volume shrinkage when heated at a low temperature of 400°C or less.

In the solids of the metal oxide film-forming composition, the ratio of the mass of the metal oxide nanoclusters to the total mass of the metal oxide nanoclusters and the base material is typically 45 mass% or more, preferably 50 mass% or more, more preferably 60 mass% or more, even more preferably 65 mass% or more. The upper limit of the mass ratio is typically 95 mass% or less, preferably 90 mass% or less.

### Solvent

The metal oxide film-forming composition according to the present invention contains a solvent for the purpose of controlling the viscosity of the composition or the ability of the composition to be applied. The solvent is typically an organic solvent. The organic solvent may be any type that allows uniform dissolution or dispersion of the components in the metal oxide film-forming composition.

Examples of the organic solvent suitable for use include ethylene glycol monomethyl ether, ethylene glycol monoethyl ether, ethylene glycol n-propyl ether, ethylene glycol mono-n-butyl ether, diethylene glycol monomethyl ether, diethylene glycol monoethyl ether, diethylene glycol mono-n-propyl ether, diethylene glycol mono-n-butyl ether, triethylene glycol monomethyl ether, triethylene glycol monoethyl ether, propylene glycol monomethyl ether, propylene glycol monoethyl ether, propylene glycol mono-n-propyl ether, propylene glycol mono-n-butyl ether, dipropylene glycol monomethyl ether, dipropylene glycol monoethyl ether, dipropylene glycol mono-n-propyl ether, dipropylene glycol mono-n-butyl ether, tripropylene glycol monomethyl ether, tripropylene glycol monoethyl ether, and other (poly)alkylene glycol monoalkyl ethers; ethylene glycol monomethyl ether acetate, ethylene glycol monoethyl ether acetate, diethylene glycol monomethyl ether acetate, diethylene glycol monoethyl ether acetate, propylene glycol monomethyl ether acetate, propylene glycol monoethyl ether acetate, and other (poly)alkylene glycol monoalkyl ether acetates; diethylene glycol dimethyl ether, diethylene glycol methyl ethyl ether, diethylene glycol diethyl ether, tetrahydrofuran, and other ethers; methyl ethyl ketone, cyclohexanone, 2-heptanone, 3-heptanone, and other ketones; methyl 2-hydroxypropionate, ethyl 2-hydroxypropionate, and other alkyl lactate esters; ethyl 2-hydroxy-2-methylpropionate, methyl 3-methoxypropionate, ethyl 3-methoxypropionate, methyl 3-ethoxypropionate, ethyl 3-ethoxypropionate, ethyl ethoxyacetate, ethyl hydroxyacetate, methyl 2-hydroxy-3-methylbutyrate, 3-methyl-3-methoxybutyl acetate, 3-methyl-3-methoxybutyl propionate, ethyl acetate, n-propyl acetate, isopropyl acetate, n-butyl acetate, isobutyl acetate, n-pentyl formate, isopentyl acetate, n-butyl propionate, ethyl butyrate, n-propyl butyrate, isopropyl butyrate, n-butyl butyrate, methyl pyruvate, ethyl pyruvate, n-propyl pyruvate, methyl acetoacetate, ethyl acetoacetate, ethyl 2-oxobutanoate, and other esters; toluene, xylene, and other aromatic hydrocarbons; and N-methylpyrrolidone, N,N-dimethylformamide, N,N-dimethylacetamide, and other amides. These organic solvents may be used alone, or two or more of these organic solvents may be used in any combination.

The amount of the solvent in the metal oxide film-forming composition according to the present invention may be any suitable level. For the ability of the metal oxide film-forming composition to be applied, the amount of the solvent in the composition is typically 30 to 99.9 mass%, preferably 50 to 98 mass%, based on the total mass of the composition.

### Surfactant

The metal oxide film-forming composition according to the present invention may further contain a surfactant (surface conditioning agent) for improving the ability to be applied, the deforming ability, the leveling ability, or other properties. The composition may contain a single surfactant or a combination of two or more surfactants. The surfactant may be, for example, a silicone surfactant or a fluorosurfactant.

Examples of the silicone surfactant include BYK-077, BYK-085, BYK-300, BYK-301, BYK-302, BYK-306, BYK-307, BYK-310, BYK-320, BYK-322, BYK-323, BYK-325, BYK-330, BYK-331, BYK-333, BYK-335, BYK-341, BYK-344, BYK-345, BYK-346, BYK-348, BYK-354, BYK-355, BYK-356, BYK-358, BYK-361, BYK-370, BYK-371, BYK-375, BYK-380, and BYK-390 (manufactured by BYK Chemie).

Examples of the fluorosurfactant include F-114, F-177, F-410, F-411, F-450, F-493, F-494, F-443, F-444, F-445, F-446, F-470, F-471, F-472SF, F-474, F-475, F-477, F-478, F-479, F-480SF, F-482, F-483, F-484, F-486, F-487, F-172D, MCF-350SF, TF-1025SF, TF-1117SF, TF-1026SF, TF-1128, TF-1127, TF-1129, TF-1126, TF-1130, TF-1116SF, TF-1131, TF-1132, TF-1027SF, TF-1441, and TF-1442 (manufactured by DIC Corporation); and PolyFox series, such as PF-636, PF-6320, PF-656, and PF-6520 (manufactured by OMNOVA Solutions).

For the ability of the metal oxide film-forming composition to be applied or the defoaming ability, the leveling ability, or other properties of the composition, the amount of the surfactant of the composition is typically, but not limited to, 0.01 to 0.15 mass%, preferably 0.05 to 0.1 mass%, based on the total mass of the components other than the solvent in the composition.

### Other Components

If necessary, the metal oxide film-forming composition according to the present invention may contain an additive, such as a dispersing agent, a thermal polymerization inhibitor, a defoaming agent, a silane coupling agent, a colorant (pigment, dye), an inorganic filler, an organic filler, a cross-linking agent, or an acid generating agent. All of the additives may be conventionally known ones. The surfactant may be, for example, an anionic, cationic, or nonionic compound. The thermal polymerization inhibitor may be, for example, hydroquinone or hydroquinone monoethyl ether. The defoaming agent may be, for example, a silicone compound or a fluoride compound.

The metal oxide film-forming composition according to the present invention may be produced by any suitable method, which may include, for example, treating the metal oxide nanoclusters with the capping agent in the presence of the solvent; then adding, to the resulting slurry, the base material, an optional solvent, an optional surfactant, and other optional components. Specifically, the metal oxide film-forming composition according to the present invention may be produced, for example, as described in the EXAMPLES section.

### Method for Producing Metal Oxide Film

The present invention is directed to a method for producing a metal oxide film, including: a coating film formation step that includes forming a coating film including the metal oxide film-forming composition according to the present invention; and a heating step that includes heating the coating film.

The coating film may be formed, for example, by applying the metal oxide film-forming composition onto a substrate, such as a semiconductor substrate. The application may be performed by a method using a contact transfer-type coating device, such as a roll coater, a reverse coater, or a bar coater, or a non-contact-type coating device, such as a spinner (rotary coater, spin coater), a dip coater, a spray coater, a slit coater, or a curtain flow coater. The viscosity of the metal oxide film-forming composition may be adjusted to fall within an appropriate range, and then the metal oxide film-forming composition may be applied by a printing method, such as screen printing, to form a coating film in a desired pattern.

The substrate preferably includes a metal film, a metal carbide film, a metal oxide film, a metal nitride film, or a metal oxynitride film. The substrate may be made of a metal including silicon, titanium, tungsten, hafnium, zirconium, chromium, germanium, copper, aluminum, indium, gallium, arsenic, palladium, iron, tantalum, iridium, molybdenum, or any alloy thereof. Preferably, the metal includes silicon, germanium, or gallium. The surface of the substrate may have asperities, which may be made of a patterned organic material.

Subsequently, if necessary, the solvent and any other volatile component may be removed so that the coating film is dried. The drying may be performed by any suitable method, which may include, for example, drying the coating film on a hot plate at a temperature of 80°C or more and 140°C or less, preferably at a temperature of 90°C or more and 130°C or less, for a time period of 60 seconds or more and 150 seconds or less. The heating on the hot plate may be preceded by drying under reduced pressure at room temperature using a vacuum drying apparatus (VCD).

After the coating film is formed in this manner, the coating film is heated. The heating temperature is preferably, but not limited to, 400°C or more, more preferably 420°C or more, even more preferably 430°C or more. The heating temperature may have any suitable upper limit, such as 600°C or less, preferably 550°C or less for the in-plane uniformity or the control of dry etch rate. In a typical mode, the heating time is preferably 30 seconds or more and 150 seconds or less, more preferably 60 seconds or more and 120 seconds or less. The heating step may be performed at a single heating temperature or may include multiple stages at different heating temperatures.

The metal oxide film formed as described above is suitable for use as a metal hard mask or a reversal patterning material, for example.

### Method for Forming Metal Oxide Film with Reduced Volume Shrinkage Ratio

As mentioned above, the present invention is directed to a method for forming a metal oxide film with a reduced volume shrinkage ratio. Specifically, the method for forming a metal oxide film with a reduced volume shrinkage ratio includes forming a coating film including a metal oxide film-forming composition; and then heating the coating film to form a metal oxide film with a reduced volume shrinkage ratio, in which the metal oxide film-forming composition is according to the present invention. The method enables the formation of a metal oxide film that exhibits a reduced volume shrinkage ratio when heated at 400°C or less and maintains in-plane uniformity when heated at 400°C or more, in particular, at 450°C or more. The metal oxide film-forming composition according to the present invention is as described above.

### EXAMPLES

Hereinafter, the present invention will be described in more detail with reference to examples, which are not intended to limit the present invention.

### Preparation of Metal Oxide Film-Forming Compositions

Each of the liquid dispersions shown below were prepared with reference to the description in paragraph [0223] of Japanese Unexamined Patent Application, Publication No. 2018-193481.

### Preparation of Dispersion Z-2

According to the description in paragraph [0223] of Japanese Unexamined Patent Application, Publication No. 2018-193481, a ZrO₂ slurry was prepared and cooled to room temperature and then centrifuged to give a wet cake (named wet cake A). To wet cake A was added 2-acryloyloxyethyl succinate (see the formula below) in an amount 0.2 times the weight of wet cake A, and the mixture was stirred. The mixture was subjected to re-precipitation and then centrifuged to give a wet cake (named wet cake B). Wet cake B was dried under reduced pressure overnight to give a powder. Propylene glycol monomethyl ether acetate (hereinafter referred to as "PGMEA") was added to the resulting dry powder to form again a dispersion with a solid content of 48 mass%. The dispersion was filtered to give a liquid dispersion (named dispersion Z-2) .

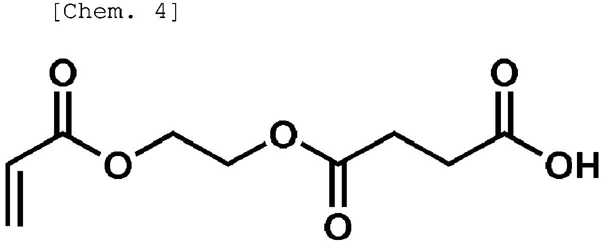

### TG-DTA (thermogravimetry-differential thermal analysis) Measurement of Dispersion Z-2

Dispersion Z-2 was placed on a platinum sample pan and subjected to TG-DTA measurement. During TG-DTA measurement, the dispersion sample was heated from room temperature to 200°C at 10°C/min. The solid mass of the sample was determined as the mass of the sample reached after it was held at 200°C for 5 minutes. Next, the sample was heated from 200°C to 710°C at 10°C/min. The inorganic mass of the sample was determined as the mass of the sample reached when the temperature reached 710°C. From these measurement results, the organic mass was calculated using the formula: organic mass = solid mass - inorganic mass, and the ratio (mass%) of the inorganic mass to the total inorganic and organic mass (formula: inorganic mass/(inorganic mass + organic mass)) was calculated to be 77 mass%. The ratio (mass%) of the organic mass to the total inorganic and organic mass (formula: organic mass/(inorganic mass + organic mass)) was also calculated to be 23 mass%.

### Measurement of the Size of Metal Oxide Nanoclusters in Dispersion Z-2

Dispersion Z-2 was used as a sample and subjected to XRD (X-ray diffraction) analysis using an X-ray diffractometer (SmartLab manufactured by Rigaku Corporation). The obtained results were analyzed using the accompanying software PDXL to determine the size of the metal oxide nanoclusters (crystallite size) by Halder-Wagner method. As a result, the size of the metal oxide nanoclusters was determined to be 8 nm.

### Preparation of Dispersion Z-1

A liquid dispersion (named dispersion Z-1) was obtained by the same procedure as in the preparation of dispersion Z-2 except that the molar ratio between water and zirconium(IV) isopropoxide isopropanol (Zr(OCH(CH₃)₂)₄(HOCH(CH₃)₂)) used to form the ZrO₂ slurry was changed to 1:3.

### TG-DTA Measurement of Dispersion Z-1

The same procedure was performed as in the TG-DTA measurement of dispersion Z-2 except that dispersion Z-1 was used instead of dispersion Z-2. As a result, the ratio (mass%) of the inorganic mass to the total inorganic and organic mass was calculated to be 73 mass%, and the ratio (mass%) of the organic mass to the total inorganic and organic mass was calculated to be 27 mass%.

### Measurement of the Size of Metal Oxide Nanoclusters in Dispersion Z-1

The same procedure was performed as in the measurement of the size of metal oxide nanoclusters in dispersion Z-2 except that dispersion Z-1 was used instead of dispersion Z-2. As a result, the size of the metal oxide nanoclusters (crystallite size) was determined to be 2.5 nm.

### Preparation of Dispersion Z-3

A liquid dispersion (named dispersion Z-3) was obtained by the same procedure as in the preparation of dispersion Z-1 except that 2-acryloyloxyethyl succinate was replaced by 2-acryloyloxyethyl phthalate.

### TG-DTA Measurement of Dispersion Z-3

The same procedure was performed as in the TG-DTA measurement of dispersion Z-1 except that dispersion Z-3 was used instead of dispersion Z-1. As a result, the ratio (mass%) of the inorganic mass to the total inorganic and organic mass was calculated to be 77 mass%, and the ratio (mass%) of the organic mass to the total inorganic and organic mass was calculated to be 23 mass%.

### Measurement of the Size of Metal Oxide Nanoclusters in Dispersion Z-3

The same procedure was performed as in the measurement of the size of metal oxide nanoclusters in dispersion Z-1 except that dispersion Z-3 was used instead of dispersion Z-1. As a result, the size of the metal oxide nanoclusters (crystallite size) was determined to be 2.5 nm.

### Preparation of Resin Solution

A resin solution was obtained by mixing 50 parts by mass of methoxyacetone with 50 parts by mass of an acrylic resin (NCF-3 (trade name) manufactured by Shin Nakamura Chemical Co., Ltd., Mw = 10,000), which includes 20 mol% of a methacrylic acid-derived structural unit and 80 mol% of a styrene-derived structural unit.

### Preparation of Surfactant Solution

A surfactant solution was obtained by mixing 1 part by mass of a commercially available surfactant (BYK-333 (trade name) manufactured by BYK Chemie) with 99 parts by mass of PGMEA.

To dispersion Z-1, Z-2, or Z-3 were added first the resin solution, then the surfactant solution, and finally the solvent PGMEA in the ratio (in units of parts by mass) shown in Table 1, and stirred. The resulting mixture was filtered with a ϕ 0.2 um membrane filter to give a composition. In Table 1, the number in the parentheses indicates the solid content (in units of parts by mass).

### Inorganic Mass Ratio

In Table 1, the "inorganic mass ratio" indicates the ratio of the inorganic mass to the total inorganic and organic mass in the solids of the composition. Specifically, a calculation was made to determine the ratio (mass%) of the inorganic mass of dispersion Z-1, Z-2, or Z-3 to the sum of the solid mass of dispersion Z-1, Z-2, or Z-3, the mass of the acrylic resin in the resin solution, and the mass of the surfactant in the surfactant solution. The results are shown in Table 1.

**[Table 1]**

| | Example1 | Example2 | Examples | Comparative Example1 |
|---|---|---|---|---|
| DISPERSION Z-1 | 2 (1.1) | 1.44 (0.792) | | |
| Size of metal oxide nanoclusters:2.5nm | | | | |
| DISPERSION Z-2 | | | | 2 (1.1) |
| Size of metal oxide nanoclusters:8nm | | | | |
| DISPERSION Z-3 | | | 2 (1.1) | |
| Size of metal oxide nanoclusters:2.5nm | | | | |
| Resin solution | 0.08 (0.04) | 0.64 (0.32) | 0.08 (0.04) | 0.08 (0.04) |
| Surfactant solution | 0.08 (0.0008) | 0.08 (0.0008) | 0.08 (0.0008) | 0.08 (0.0008) |
| Solvent (PMGEA) | 17.84 | 17.84 | 17.84 | 17.84 |
| Capping agent type* | A | A | B | A |
| Inorganic mass ratio(mass%) | 70 | 50 | 70 | 70 |

| | | | | |
|---|---|---|---|---|
| *A:2-Acryloyloxyethyl succinate B:2-Acryloyloxyethyl phthalate | | | | |

### Preparation of Metal Oxide Film

The composition was dropped on a 6-inch silicon wafer, which was accelerated to 500 rpm in 2 seconds and then spincoated with the composition at 500 rpm for 10 seconds. Subsequently, using a hot plate, the composition was pre-baked at 100°C for 120 seconds and then post-baked for 90 seconds at each of the baking temperatures shown below to form a metal oxide film. In this regard, the term "room temperature" shown below represents allowing the pre-baked composition to stand at room temperature for 90 seconds, which means no actual post-baking. Baking temperatures: room temperature, 200°C, 250°C, 300°C, 350°C, 400°C, 450°C, 500°C, and 600°C

### Measurement of Film Thickness

SEM (scanning electron microscopy) observation was performed on the cross section of the resulting metal oxide film to determine the thickness of the film. The results are shown in Table 2. Table 2 shows the percentage ratio of the thickness of each film to the thickness of the film obtained when the baking temperature was set to room temperature in the preparation of the metal oxide film described above, which was normalized to 100%.

**[Table 2]**

| Baking temperature | Example1 | Example2 | Examples | Comparative Example1 |
|---|---|---|---|---|
| Room temperature | 100% | 100% | 100% | 100% |
| 200 | 98% | 98% | 98% | 95% |
| 250 | 96% | 92% | 92% | 85% |
| 300 | 95% | 92% | 88% | 77% |
| 350 | 93% | 86% | 86% | 77% |
| 400 | 87% | 81% | 80% | 74% |
| 450 | 76% | 68% | 73% | 70% |
| 500 | 67% | 64% | 68% | 66% |
| 600 | 65% | 63% | 63% | 62% |

Table 2 indicates that in each of the examples, the film exhibited relatively low volume shrinkage when heated at 400°C or less whereas in the comparative example, the film exhibited significantly high volume shrinkage when heated at 400°C or less.

## Claims

1. A metal oxide film-forming composition comprising: metal oxide nanoclusters; a capping agent; a base material; and a solvent,
the metal oxide nanoclusters having a size of 5 nm or less,
the capping agent comprising at least one selected from the group consisting of an alkoxysilane, a phenol, an alcohol, a carboxylic acid, and a carboxylic acid halide,
the metal oxide film-forming composition containing solids with a ratio of inorganic mass to total inorganic and organic mass of 25 mass% or more.

2. The metal oxide film-forming composition according to claim 1, wherein the metal oxide film-forming composition contains solids with a ratio of the mass of the metal oxide nanoclusters to the total mass of the metal oxide nanoclusters and the capping agent of 50 mass% or more.

3. The metal oxide film-forming composition according to claim 1 or 2, further comprising a surfactant.

4. The metal oxide film-forming composition according to any one of claims 1 to 3, wherein the metal oxide nanoclusters comprise at least one metal selected from the group consisting of zinc, yttrium, hafnium, zirconium, lanthanum, cerium, neodymium, gadolinium, holmium, lutetium, tantalum, titanium, silicon, aluminum, antimony, tin, indium, tungsten, copper, vanadium, chromium, niobium, molybdenum, ruthenium, rhodium, rhenium, iridium, germanium, gallium, thallium, and magnesium.

5. A method for producing a metal oxide film, the method comprising:
a coating film formation step that comprises forming a coating film comprising the metal oxide film-forming composition according to any one of claims 1 to 4; and
a heating step that comprises heating the coating film.

6. The method according to claim 5, wherein the heating step is performed at a heating temperature of 400°C or more.

7. The method according to claim 5 or 6, wherein the metal oxide film is a metal hard mask.

8. A method for forming a metal oxide film with a reduced volume shrinkage ratio, the method comprising: forming a coating film comprising a metal oxide film-forming composition; and heating the coating film,
the metal oxide film-forming composition comprising: metal oxide nanoclusters; a capping agent; a base material; and a solvent,
the metal oxide nanoclusters having a size of 5 nm or less,
the capping agent comprising at least one selected from the group consisting of an alkoxysilane, a phenol, an alcohol, a carboxylic acid, and a carboxylic acid halide,
the metal oxide film-forming composition containing solids with a ratio of inorganic mass to total inorganic and organic mass of 25 mass% or more.
